(19) Europäisches Patentamt
European Patent Office
Office européen des brevets

(11) EP 1 518 886 B1

(12) EUROPÄISCHE PATENTSCHRIFT

(45) Veröffentlichungstag und Bekanntmachung des Hinweises auf die Patenterteilung:
**14.05.2008 Patentblatt 2008/20**

(51) Int Cl.:
***C08J 5/18*** (2006.01) ***C08K 3/22*** (2006.01)
***C08L 67/02*** (2006.01) ***C23C 18/16*** (2006.01)
***H05K 3/18*** (2006.01)

(21) Anmeldenummer: **04022019.6**

(22) Anmeldetag: **16.09.2004**

(54) **Mehrschichtige, orientierte, mittels elektromagnetischer Strahlung strukturierbare Folie aus thermoplastischem Polyester zur Herstellung selektiv metallisierter Folien**

Multi layered, oriented, with electromagnetic radiation patternable foil made of thermoplastic polyester for the production of selectively metallized foils

Feuille orientée multicouche, structurable par rayonnement électromagnétique, à base de polyester thermoplastique, pour la préparation de feuilles métallisées sélectivement

(84) Benannte Vertragsstaaten:
**DE FR GB LU**

(30) Priorität: **24.09.2003 DE 10344513**

(43) Veröffentlichungstag der Anmeldung:
**30.03.2005 Patentblatt 2005/13**

(73) Patentinhaber: **Mitsubishi Polyester Film GmbH**
**65203 Wiesbaden (DE)**

(72) Erfinder:
- **Kliesch, Holger, Dr.**
**55252 Mainz (DE)**
- **Kiehne, Thorsten, Dr.**
**65185 Wiesbaden (DE)**
- **Hilkert, Gottfried, Dr.**
**55291 Saulheim (DE)**
- **Hora, Franz**
**65830 Kriftel (DE)**

(74) Vertreter: **Schweitzer, Klaus et al**
**Zounek Plate Schweitzer**
**Patentanwaltskanzlei**
**Rheingaustrasse 196**
**65203 Wiesbaden (DE)**

(56) Entgegenhaltungen:
**EP-A- 0 577 197**
**EP-A- 1 274 288**
**DE-A- 19 723 734**
**US-A- 5 470 637**

EP 1 518 886 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft eine mehrschichtige, orientierte Folie, bei der mindestens eine Schicht einen Polyester enthält, der ein Additiv enthält, welches unter Bestrahlung mit elektromagnetischer Strahlung Metallkeime bildet, an denen sich in weiteren Prozessschritten weiteres Metall anlagern lässt. Die Erfindung betrifft ferner ein Verfahren zur Herstellung dieser Folie und ihre Verwendung in Leiterplatten, Flachbandkabeln, Smartcards, RFID-Labels, Folientastaturen und folienbasierten Schaltungen aller Art.

Die Verwendung von Polyesterfolien für Elektroisolieranwendungen ist Stand der Technik. Die immer höheren Anforderungen hinsichtlich Komplexität der Schaltungen auf kleinem Raum sowie die Notwendigkeit solche Schaltungen schnell, flexibel und kostengünstig produzieren zu können, stellt hohe technologische Anforderungen an die Folie und die Weiterverarbeitungsschritte.

Konventionelle Verfahren zur Herstellung flexibler Schaltungen betreffen meist die vollflächige Metallisierung der Folienbahn oder Kaschierung der Folienbahn mit Metallfolie und anschließendes Strukturieren der so entstandenen leitfähigen Flächen mit verschiedenen Verfahren, z.B. Ätzen oder mechanisches Entfernen der unerwünschten Metallmengen. Oder aber Verfahren, bei denen das Metall aufgeprägt/aufgedruckt wird, oder eine Leitpaste aus Kohle/Silber aufgetragen wird. Nachteile dieser Verfahren liegen in der geringen Flexibilität und Präzision solcher Verfahren, welche einen größeren Abstand der Leiterbahnen untereinander bedingt und/ oder der hohen mit diesen Verfahren verbundenen Kosten und/oder der niedrigen Produktionsgeschwindigkeiten.

In EP-A-1 274 288 wird ein Verfahren beschrieben, bei dem aus kupferhaltigen Metalloxiden durch Laserbestrahlung Kupferkeime gebildet werden, an denen in einem anschließenden Galvanisierungsschritt weiteres Kupfer abgeschieden wird. In dieser Druckschrift werden ausschließlich Spritzgussteile beschrieben, und es fehlen Hinweise wie und ob das Verfahren für Polyesterfolien und Folien im Allgemeinen angewendet werden kann. Insbesondere fehlen Hinweise, wie die Rohstoffe und Additive beschaffen sein müssen, um daraus orientierte Folien herstellen zu können. Das in EP-A-1 274 288 beschriebene PBT / $SiO_2$ / Spinell Compound ist zur Herstellung orientierter Folien ungeeignet, da das verwendetete Polybutylenterephthalat aufgrund seiner hohen Kristallisationsgeschwindigkeit und des hohen Füllgrads mit pyrogener Kieselsäure nicht verfahrenssicher verarbeitbar ist.

Insbesondere fehlen Hinweise wie eine Folie mit hinreichender Dimensionsstabilität bei lokaler Erwärmung nach Bestrahlung mit elektromagnetischer Strahlung und Weiterverarbeitung hergestellt werden kann.

Aufgabe der vorliegenden Erfindung war es, eine Folie bereitzustellen, welche die genannten Nachteile nicht aufweist und die eine strahlungsaktivierbare Verbindung enthält, die Metallkeime bildet, an denen sich in weiteren Verfahrensschritten weiteres Metall anlagern lässt. Weiterhin sollte eine solche Folie neben einer wirtschaftlichen Herstellung und einer guten Verstreckbarkeit, gute mechanische Eigenschaften, das bedeutet eine hohe Reißfestigkeit in Längs- und Querrichtung, einen hohen E-Modul in Längs- und Querrichtung, eine hohe Reißdehnung in Längs- und Querrichtung und eine hohe Zugspannung zur Erzeugung einer Dehnung von 5 % (F5-Wert) in Längs- und Querrichtung aufweisen sowie gegebenenfalls einen definierten Schrumpf aufweisen.

Gelöstwird diese Aufgabe durch eine mehrschichtige, mindestens monoaxial orientierte Polyesterfolie mit einer Gesamtdicke von 5 - 500 $\mu$m (bevorzugt 12 - 200 $\mu$m und besonders bevorzugt 30 - 150 $\mu$m), die in mindestens einer Schicht eine durch elektromagnetische Strahlung aktivierbare Metallverbindung enthält, welche ein Spinell ist, bevorzugt in einer Menge von 0,1 - 15 Gew.-% (besonders bevorzugt 1,0 - 10 Gew.-% und ganz besonders bevorzugt 2,0 - 8,0 Gew.-%), bezogen auf das Gesamtgewicht der ausgerüsteten Schicht.

Unter einer strahlungsaktivierbaren Metallverbindung ist ein Spinell zu verstehen, der infolge einer Absorption von elektromagnetischer Strahlung in einer chemischen Reaktion Metall in elementarer Form freisetzt. Diese chemische Reaktion kann auch unter Beteiligung weiterer Reaktionspartner erfolgen. Weiterhin ist es möglich, dass die elektromagnetische Strahlung nicht direkt von der metallhaltigen Verbindung absorbiert wird, sondern durch andere Substanzen, die anschließend die absorbierte Energie auf die metallhaltige Verbindung übertragen und so die Freisetzung von elementarem Metall bewirken. Bei der elektromagnetischen Strahlung kann es sich beispielsweise um UV-Licht (Wellenlänge 100 - 400 nm), sichtbares Licht (Wellenlänge 400 - 800 nm) oder Infrarotlicht (Wellenlänge 800 - 25000 nm) handeln, wobei die Verwendung von Infrarotlicht bevorzugt ist. Weitere bevorzugte Strahlungsformen sind Röntgen-, Gamma- und Partikelstrahlung (Elektronen-, $\alpha$- und $\beta$-Strahlung).

Die Anlagerung von weiterem Metall an die durch elektromagnetische Strahlung erzeugten Metallkeime erfolgt bevorzugt durch galvanische (nasschemische) Verfahren.

Zu einer guten Verstreckbarkeit zählt, dass sich die Folie bei ihrer Herstellung hervorragend uniaxial oder biaxial ohne Abrisse orientieren lässt.

Zu den guten mechanischen Eigenschaften zählen unter anderem ein hoher E-Modul in mindestens einer Folienrichtung (Längsrichtung (MD) und/oder Querrichtung (TD)) von größer als 500 $N/mm^2$ bevorzugt größer als 2000 $N/mm^2$ und besonders bevorzugt von größer als 4000 $N/mm^2$, sowie hohe Reißfestigkeitswerte in mindestens einer Folienrichtung (Längsrichtung (MD) und/oder Querrichtung (TD)) von größer als 50 $N/mm^2$, bevorzugt größer als 100 $N/mm^2$ und besonders bevorzugt von größer als 150 $N/mm^2$; hohe Reißdehnungswerte in mindestens einer Folienrichtung (Längsrichtung (MD) und/oder Querrichtung (TD)) von größer als 10 % bevorzugt größer als 40 % und besonders bevorzugt von größer als 80 %.

Die erfindungsgemäße Folie weist in einer bevorzugten Ausführungsform in keiner Folienrichtung (weder in MD noch in TD) einen Schrumpf bei 200 °C von größer 25 % auf. Der Schrumpf bei 200 °C ist bevorzugt kleiner als 15 % und besonders bevorzugt kleiner als 5 %.

Die erfindungsgemäße mehrschichtige Folie basiert auf Polyestern. Insbesondere die Basisschicht, aber auch die Deck- und oder Zwischenschichten enthalten als Hauptpolymerbestandteil (d.h. zu 55 - 100 Gew.-%, bevorzugt 70 - 100 Gew.-% und besonders bevorzugt 90 - 100 Gew.-%, bezogen auf die Masse der jeweiligen Schicht) einen Polyester.

Erfindungsgemäß versteht man unter einem Polyester

- Homopolyester,
- Copolyester,
- Blends verschiedener Polyester,

wobei diese sowohl als reine Rohstoffe, als auch als Rezyklat enthaltende Polyester-Rohstoffe eingesetzt werden können.

Polyester enthalten Wiederholungseinheiten, die sich von Dicarbonsäuren (100 Mol-%) und Diolen (ebenfalls 100 Mol-%) ableiten. Die erfindungsgemäßen Polyester basieren bevorzugt auf Terephthalsäure oder 2,6-Naphthalindicarbonsäure als Dicarbonsäure und auf Ethylenglykol als Diol.

Insbesondere enthalten die erfindungsgemäßen Polyester 10 - 100 Mol-% Terephthalat oder 10 -100 Mol-% 2,6-Naphthalat als Dicarbonsäurekomponeneten (wobei die Gesamtmenge an Dicarbonsäurekomponeten 100 Mol-% ausmachen). Als weitere Dicarbonsäurekomponeneten kann der erfindungsgemäße Polyester 0 - 50 Mol-% 2,6-Naphthalat (wenn als Hauptkomponente Terephthalat eingesetzt wurde), 0 - 50 Mol-% Terephthalat (wenn als Hauptkomponente Naphthalat verwendet wurde), 0 - 20 Mol-% Isophthalat (bevorzugt 0,5 - 4 Mol-%) sowie 10 - 60 Mol-% 4,4'-Diphenyldicarboxylat enthalten. Andere Dicarbonsäurekomponeneten wie 1,5-Naphthalindicarboxylat sollten einen Anteil von 30 Mol-%, bevorzugt 10 Mol-%, insbesondere 2 Mol-%, nicht überschreiten.

Als Diolkomponente enthält der erfindungsgemäße Polyester 10 - 100 Mol-% Ethylenglykol (EG) (wobei die Gesamtmenge an Diolkomponenten 100 Mol-% ausmachen). Der Anteil an Diethylenglykol sollte 10 Mol-% nicht überschreiten und liegt idealerweise zwischen 0,5 und 5 Mol-%. Andere Diolkomponenten wie Cyclohexandimethanol, 1,3-Propandiol, 1,4-Butandiol sollten einen Anteil von 50 Mol-% nicht überschreiten und liegen bevorzugt bei einem Anteil von weniger als 30 Mol-%, besonders bevorzugt bei weniger als 10 Mol-%.

Die Polyesterzusammensetzung funktioneller Deckschichten kann von dem oben beschriebenen abweichen und ist z.B. im Absatz über siegelfähige Deckschichten weiter unten beschrieben.

Neben den genannten Hauptpolymerbestandteilen können die Schichten der Folie in weiteren Ausführungsformen bis zu 45 Gew.-% (bevorzugt bis zu 30 Gew.-%, besonders bevorzugt bis zu 20 Gew.-%, bezogen auf die Masse der jeweiligen Folienschicht) andere Polymere wie Polyetherimide (z.B. ®Ultem 1000 von GE Plastics Europe, NL), Polycarbonat (z.B. ®Makrolon von Bayer, DE), Polyolefine wie COCs (z.B. ®Topas von Ticona, DE), Polyamide (®Ultramid von BASF, DE) u.a. enthalten.

Allgemein werden die Polyester nach literaturbekannten Verfahren aus den genannten Diolen und Dicarbonsäure oder Dicarbonsäureester hergestellt. Die Herstellung der Polyester kann sowohl nach dem Umesterungsverfahren mit den üblichen Katalysatoren wie z.B. Zn-, Ca-, Li- und Mn-Salzen oder nach dem Direktveresterungsverfahren erfolgen.

Die erfindungsgemäße mehrschichtige Folie besteht aus einer Basisschicht B, mindestens einer Deckschicht A oder C und gegebenenfalls weiteren Zwischenschichten, wobei insbesondere ein dreischichtiger A-B-A- oder A-B-C-Aufbau bevorzugt ist. Für diese Ausführungsform ist es vorteilhaft, wenn das Polymer der Basisschicht B eine ähnliche Schmelzeviskosität besitzt wie jene(s) der Deckschicht(en), die an die Basisschicht angrenzt (angrenzen).

In einer bevorzugten Ausführungsform ist die funktionelle Schicht C siegelfähig. Diese durch Coextrusion auf die Basisschicht B aufgebrachte siegelfähige Deckschicht ist auf Basis von Polyestercopolymeren aufgebaut. Bevorzugt im Sinne der Erfindung sind dabei zwei Varianten.

a: Copolyester aus Terephthalsäure und Isophthalsäure
b: Copolyester aus Terephthalsäure und Naphthalindicarbonsäure

Variante a:

Das Polymer der siegelfähige Deckschicht besteht aus Copolyestern, die überwiegend, das heißt zu mindestens 70-95 Mol-% aus Isophthalsäure- und Terephthalsäure-Komponenten auf der Dicarbonsäure-Seite und 70-95 Mol-% aus Ethylenglykol-Komponenten auf der Diol-Seite zusammengesetzt sind. Die restlichen Monomereinheiten stammen aus anderen aliphatischen, cycloaliphatischen oder aromatischen Diolen bzw. Dicarbonsäuren, wie sie auch in der

Basisschicht vorkommen können. Die bevorzugten Copolyester, die die gewünschten Siegeleigenschaften bereitstellen, sind solche, die aus Ethylenterephthalat- und Ethylenisophthalat-Komponenten aufgebaut sind. Der Anteil an Ethylenterephthalat beträgt 40 bis 95 Mol-% und der entsprechende Anteil an Ethylenisophthalat 60 bis 5 Mol-%. Bevorzugt sind Copolyester, bei denen der Anteil an Ethylenterephthalat 50 bis 90 Mol-% und der entsprechende Anteil an Ethylenisophthalat 50 bis 10 Mol-% beträgt und ganz bevorzugt sind Copolyester, bei denen der Anteil an Ethylenterephthalat 60 bis 85 Mol-% und der entsprechende Anteil an Ethylenisophthalat 40 bis 15 Mol-% beträgt.

Variante b:

Das Polymer der siegelfähige Deckschicht besteht aus Copolyestern, die überwiegend das heißt zu mindestens 70-95 Mol-% aus Naphthalindicarbonsäure- und Terephthalsäure-Komponenten auf der Dicarbonsäure-Seite und aus Ethylenglykol-Komponenten auf der Diol-Seite zusammengesetzt sind. Die restlichen Monomereinheiten stammen aus anderen aliphatischen, cycloaliphatischen oder aromatischen Diolen bzw. Dicarbonsäuren, wie sie auch in der Basisschicht vorkommen können. Die bevorzugten Copolyester, die die gewünschten Siegeleigenschaften bereitstellen, sind solche, die aus Ethylenterephthalat- und Ethylennaphthalat-Komponenten aufgebaut sind. Der Anteil an Ethylenterephthalat beträgt 30 bis 75 Mol-% und der entsprechende Anteil an Ethylennaphthalat 70 bis 25 Mol-%. Bevorzugt sind Copolyester, bei denen der Anteil an Ethylenterephthalat 40 bis 60 Mol-% und der entsprechende Anteil an Ethylennaphthalat 60 bis 40 Mol-% beträgt. Sollte der Gehalt an Polyethylennaphthalat (PEN) in der Siegelschicht nicht ausreichen, um den erfindungsgemäßen Gesamtgehalt an PEN in der Folienschicht zu erreichen, so sollte zweckmäßigerweise der fehlende PEN-Anteil der Basisschicht hinzugefügt werden und es sollte zweckmäßigerweise eine PEN-freie Deckschicht aufgebracht werden.

Die Varianten a und b können miteinander kombiniert werden. Die Mindestmengen an Isophthalsäure (IPA) bzw. PEN lassen sich dadurch verringern. Es hat sich bei PET/PEN/Polyethylenisophthalat-Siegelschichten (PET=Polyethylenterephthalat) jedoch als günstig erwiesen, wenn der PEN-Anteil der Siegelschicht bei mindestens 15 Gew.-% und der Polyethylenisophthalatanteil bei mindestens 5 Gew.-% liegt.

Die Dicke der Deckschicht/en wird unabhängig von den anderen Schichten gewählt und liegt bevorzugt im Bereich von 0,1 bis 10 μm, insbesondere 0,2 bis 5 μm, vorzugsweise 1 bis 3 μm, wobei beidseitig aufgebrachte Deckschichten bezüglich Dicke und Zusammensetzung gleich oder verschieden sein können. Die Dicke der Basisschicht ergibt sich entsprechend aus der Differenz von Gesamtdicke der Folie und der Dicke der aufgebrachten Deck- und Zwischenschicht/en und kann daher analog der Gesamtdicke innerhalb weiter Grenzen variieren.

Die strahlungsaktivierbare Verbindung ist ein Spinell, der bevorzugt in wässrigen sauren oder alkalischen Metallisierungsbädern beständig und nicht löslich ist. Besonders geeignet sind solche Verbindungen, die Licht, insbesondere im IR-Bereich möglichst vollständig absorbieren. Solche Verbindungen sind in EP-A-1 274 288 beschrieben. Bevorzugt sind hierbei Verbindungen von Metallen der d- und f-Gruppe des Periodischen Systems mit Nichtmetallen. Es handelt sich bei den metallhaltigen Verbindungen um Metalloxide, insbesondere um Monoxide der d-Metalle des Periodischen Systems. Geeignet sind höhere Metalloxide. Gemäß der Erfindung sind die höheren Oxide Spinelle, insbesondere kupferhaltige Spinelle wie $CuCr_2O_4$. Geeignete kupferhaltige Spinelle sind kommerziell erhältlich, so z.B. der Typ PK 3095 der Fa. Ferro (DE) oder die Typen 34E23 oder 34E30 der Firma Johnson Matthey (DE).

Die erfindungsgemäße Folie enthält diese Verbindungen in einer Konzentration von 0,1 - 15 Gew.-%, bevorzugt 1,0 - 10 Gew.-% und besonders bevorzugt 2,0 - 8,0 Gew.-%. Diese Gesamtkonzentration kann sich hierbei auf zwei oder mehrere Schichten der Folie verteilen, bevorzugt wird die Gesamtmenge jedoch den Deckschichten, bevorzugt einer der Deckschichten zugegeben.

Sofern die metallhaltige Verbindung in dem zur Folienherstellung verwendeten Polyester nicht löslich ist, handelt es sich um Partikel mit einer mittleren Größe ($d_{50}$-Wert) von 0,01 - 20 μm, bevorzugt 0,05 - 10 μm und besonders bevorzugt 0,1 - 5 μm.

Mehr als überraschend war hierbei, dass es völlig ausreicht ausschließlich die, im Verhältnis zur Gesamtdicke der Folie, dünne(n) Deckschicht(en) der Folie mit der beschriebenen strahlungsaktivierbaren Verbindung auszurüsten, um eine durch elektromagnetische Strahlung strukturierbare Folie zu erhalten, die für die genannten Anwendungen geeignet ist. Von besonderem wirtschaftlichen Vorteil ist in diesem Fall, dass insgesamt eine erheblich geringere Menge der strahlungsaktivierbaren Verbindung zur Herstellung der erfindungsgemäßen Folie notwendig ist, als bei zusätzlichen Ausrüstung der Basisschicht oder bei Ausrüstung der gesamten Folie.

Die erfindungsgemäße Folie kann in einer oder mehreren Schichten weitere partikuläre Additive wie Füllstoffe und Antiblockmittel enthalten. Typische Füllstoffe und Antiblockmittel sind anorganische und/oder organische Partikel, beispielsweise Siliciumdioxid (gefällt oder pyrogen), Calciumcarbonat, Magnesiumcarbonat, Bariumcarbonat, Calciumsulfat, Bariumsulfat, Lithiumphosphat, Calciumphosphat, Magnesiumphosphat, Titandioxid (Rutil oder Anatas), Kaolin (hydratisiert oder calciniert), Aluminiumoxid, Aluminiumsilikate, Lithiumfluorid, Calcium-, Barium-, Zink- oder Mangansalze der eingesetzten Dicarbonsäuren oder vernetzte Polymerpartikel, z.B. Polystyrol oder Polymethylmethacrylatpartikel.

Es können auch Mischungen von zwei oder mehreren der oben genannten Partikelsysteme oder Mischungen von Partikelsystemen mit gleicher chemischer Zusammensetzung, aber unterschiedlicher Partikelgröße gewählt werden. Die Partikel werden dem Polyester zweckmäßigerweise schon vor dem Aufschmelzen zugesetzt.

Sofern in einer Schicht der Folie weitere partikuläre Additive enthalten sind, beträgt die Gesamtkonzentration dieser Partikel weniger als 30 Gew.-% bezogen auf die Gesamtmasse der ausgerüsteten Schicht, bevorzugt weniger als 25 Gew.-% und besonders bevorzugt weniger als 20 Gew.-%. Die partikulären Additive haben eine mittlere Größe ($d_{50}$-Wert) von 0,01 - 15 μm, bevorzugt 0,03 - 10 μm und besonders bevorzugt 0,05 - 1 μm. In einer bevorzugten Ausführungsform liegt der Anteil von Partikeln mit einem $d_{50}$ > 3 μm bei kleiner 2000 ppm und besonders bevorzugt bei < 1000 ppm.

Es hat sich gezeigt, dass auch Folien ohne weitere Additive (außer der aktiven Metallkomponente) gemäß der Erfindung eingesetzt werden können. Die Bildung der Metallkeime wird jedoch verbessert, wenn mindestens eine Schicht der Folie als Füllstoff Siliciumdioxid in den oben genannten Mengen und Teilchengrößen enthält. Für die Bildung der Metallkeime hat es sich als besonders günstig erwiesen, wenn die Folie in der (den) mit der strahlungsaktivierbaren Komponente ausgerüsteten Schicht(en) zusätzlich 0,1 bis 30 Gew.-%, bevorzugt 0,5 bis 25 Gew.-% und besonders bevorzugt 1 bis 20 Gew.-% (bezogen auf die Gesamtmasse der ausgerüsteten Schicht), Siliciumdioxid-Partikel mit einem $d_{50}$ < 1 μm enthält (enthalten).

Die erfindungsgemäße Folie kann weitere Additive wie UV-Stabilisatoren, Flammschutzmittel, Hydrolysestabilisatoren und Antioxidantien enthalten.

In einer weiteren Ausführungsform ist die erfindungsgemäße Folie in mindestens einer ihrer Schichten flammhemmend ausgerüstet. Flammhemmend bedeutet, dass die Folie in einer sogenannten Brandschutzprüfung gemäß UL94 VTM mindestens die Klasse VTM-2 erreichen. Die Folie enthält dann in einer oder mehreren Schichten ein Flammschutzmittel in einer Konzentration im Bereich von 0,2 bis 30 Gew.-%, bevorzugt 0,5 bis 25 Gew.-%, besonders bevorzugt von 1,0 bis 20 Gew.-%, bezogen auf die Masse der ausgerüsteten Schicht. Wesentlich ist, dass das Flammschutzmittel im Polyester löslich ist, da andernfalls die geforderten mechanischen Eigenschaften nicht erreicht werden. Geeignete Flammschutzmittel sind beispielsweise organische Brom-, Chlor- oder Stickstoffverbindungen oder Metallhydroxide oder -trihydrate. Die Halogenverbindungen haben allerdings den Nachteil, dass im Brandfall toxische und korrosiv wirkende Halogenwasserstoffe entstehen. Nachteilig ist auch die geringe Lichtbeständigkeit einer damit ausgerüsteten Folie. Weitere geeignete Flammschutzmittel sind beispielsweise organische Phosphorverbindungen wie Carboxyphosphinsäuren, deren Anhydride und Methanphosphonsäuredimethylester. Sehr geeignet sind hierbei Flammschutzmittel, bei denen die Phosphorverbindung chemisch an den Polyester gebunden ist. Ganz besonders bevorzugt ist [(6-oxido-6H-dibenz[c,e][1,2]oxaphosphorin-6-yl)methyl]butandicarbonsäure-bis-(2-hydroxyethyl)ester mit der Formel

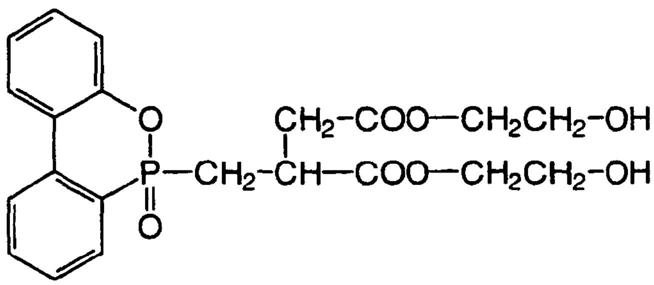

In dieser bevorzugten Ausführungsform enthält die erfindungsgemäße schwer entflammbare Folie neben dem Polyester, der strahlungsaktivierbaren Verbindung und gegebenenfalls partikulären Additiven, 1 bis 20 Gew.-% einer im Polyester löslichen organischen Phosphorverbindung als Flammschutzmittel.

Da die Flammschutzmittel im allgemeinen eine gewisse Hydrolyseempfindlichkeit aufweisen, kann der zusätzliche Einsatz eines Hydrolysestabilisators sinnvoll sein. Geeignete Hydrolysestabilisatoren sind beispielsweise polymere Carbodiimide wie z.B. ®Stabaxol P von Fa. Rheinchemie (DE). Diese werden bevorzugt in einer Menge von 0,1 bis 1,0 Gew.-% (bezogen auf die Masse der ausgerüsteten Schicht) eingesetzt.

Diese oben genannten Anteile an Flammschutzmittel und Hydrolysestabilisator haben sich auch dann als günstig erwiesen, wenn der Hauptbestandteil der Folie nicht Polyethylenterephthalat, sondern ein anderer Polyester ist.

Die strahlungsaktivierbare Verbindung und die ggf. verwendeten weiteren Additive wie Partikel, UV-Stabilisatoren, Flammschutzmittel, Hydrolysestabilisatoren und Antioxidantien können dem zur Herstellung der erfindungsgemäßen Folie verwendeten Polyester als glykolische Dispersion während der Polykondensation zugegeben werden. Bevorzugt ist jedoch die Zugabe der strahlungsaktivierbaren Komponente und/oder der ggf. verwendeten weiteren Additive über Masterbatche zum Polyesterrohstoff während der Folienextrusion.

Ebenso kann die Folie zur Einstellung weiterer Eigenschaften beschichtet werden. Typische Beschichtungen sind insbesondere haftvermittelnd, antistatisch, schlupfverbessernd oder dehäsiv wirkende Schichten. Es bietet sich an, diese zusätzlichen Schichten über in-line coating mittels wässriger Dispersionen nach der Längs- und vor der Querstreckung auf die Folie aufzubringen.

In einer besonderen Ausführungsform weist die Folie mindestens einseitig eine Silikonbeschichtung auf wie sie z.B. in der US-A-5,728,339 beschrieben ist. Diese Ausführungsform hat den Vorteil, dass nach der Laserbehandlung die umliegenden Bereiche vor der korrodierenden Wirkung des galvanischen Bades geschützt sind und sich Reste der Galvaniklösung leichter von der Folienoberfläche entfernen lassen.

Für bestimmte Anwendungen kann es zweckmäßig sein, die Oberfläche der Folie mit einer Säure chemisch vorzubehandeln. Für diese sogenannte Ätzhaftvermittlung eignen sich insbesondere Trichloressigsäure, Dichloressigsäure oder Flusssäure, die für eine kurze Zeit (zwischen 5 und 120 Sekunden) auf die Oberfläche einwirken und dann mittels Luftmesser wieder entfernt werden. Dadurch erhält die Folie eine sehr reaktive, amorphe Oberfläche.

Die Additive, also die strahlungsaktivierbare Metallverbindung sowie die gegebenenfalls vorhandenen weiteren Füllstoffe und sonstigen Additive, können mittels eines handelsüblichen Zweischneckenextruders (z.B. von Coperion) in das Polymer eingebracht werden. Dabei wird ein erfindungsgemäßes Polyestergranulat zusammen mit den Partikel/Additiven in den Extruder eingebracht und extrudiert, anschließend in einem Wasserbad abgeschreckt und dann granuliert.

In einem bevorzugten Verfahren zur Herstellung der erfindungsgemäßen Polyester werden die Additive aber direkt bei der Polyesterherstellung zugegeben. Üblicherweise werden die Additive im Falle des DMT-Verfahrens nach der Umesterung bzw. direkt vor der Polykondensation (z.B. über die Transportleitung zwischen Umesterungs- und Polykondensationskessel) als glykolische Dispersion zugegeben. Die Zugabe kann aber auch schon vor der Umesterung erfolgen. Im Falle des TPA-Verfahrens erfolgt die Zugabe bevorzugt zu Beginn der Polykondensation. Eine spätere Zugabe ist jedoch auch möglich. Es hat sich bei diesem Verfahren als günstig erwiesen, wenn die glykolischen Dispersionen vor der Zugabe über einen PROGAF PGF 57 (Hayward Ind. USA) Filter filtriert werden.

Gegenstand der vorliegenden Erfindung ist auch ein Verfahren zur Herstellung der Folie. Allgemein erfolgt die Herstellung durch ein an sich bekanntes Extrusions- oder Koextrusionsverfahren. Als besonders vorteilhaft hat es sich erwiesen, die strahlungsaktivierbare Komponente und die ggf. verwendeten weiteren Additive wie Partikel, UV-Stabilisatoren, Flammschutzmittel, Hydrolysestabilisatoren und Antioxidantien in Form von vorgetrockneten oder vorkristallisierten Masterbatchen vor der Extrusion zuzugeben.

Bevorzugt bei der Masterbatchtechnologie ist, dass die Korngröße und das Schüttgewicht der Masterbatche ähnlich der Korngröße und dem Schüttgewicht des verwendeten Polyesterrohstoffs ist, so dass eine homogene Verteilung erreicht wird, aus der homogene Eigenschaften resultieren.

Die Polyesterfolien können nach bekannten Verfahren aus einem Polyesterrohstoff, und gegebenenfalls weiteren Rohstoffen, mindestens einer strahlungsaktivierbaren Komponente sowie gegebenenfalls weiteren Additiven als mehrschichtige Folie hergestellt werden.

Masterbatche, die die strahlungsaktivierbare Komponente enthalten, sind bevorzugt vorkristallisiert und/oder vorgetrocknet. Das gleiche gilt für Masterbatche, die Partikel, UV-Stabilisator(en), Flammschutzmittel und/oder andere Additive enthalten. Die Vortrocknung beinhaltet ein graduelles Erhitzen der Masterbatche unter reduziertem Druck (20 bis 80 mbar, vorzugsweise 30 bis 60 mbar, insbesondere 40 bis 50 mbar) sowie Rühren und gegebenenfalls ein Nachtrocknen bei konstanter, erhöhter Temperatur (ebenfalls unter reduziertem Druck). Die Masterbatche werden vorzugsweise bei Raumtemperatur aus einem Dosierbehälter in der gewünschten Abmischung zusammen mit dem Polyesterrohstoff und gegebenenfalls anderen Rohstoffkomponenten chargenweise in einen Vakuumtrockner, der im Laufe der Trocken- bzw. Verweilzeit ein Temperaturspektrum von 10 bis 160 °C, vorzugsweise 20 bis 150 °C, insbesondere 30 bis 130 °C durchläuft, gefüllt. Während der etwa 6-stündigen, vorzugsweise 5-stündigen, insbesondere 4-stündigen Verweilzeit wird die Rohstoffmischung mit 10 bis 70 Upm, vorzugsweise 15 bis 65 Upm, insbesondere 20 bis 60 Upm, gerührt. Das so vorkristallisierte bzw. vorgetrocknete Rohstoffgemisch wird in einem nachgeschalteten ebenfalls evakuierten Behälter bei 90 bis 180 °C, vorzugsweise 100 bis 170 °C, insbesondere 110 bis 160 °C, für 2 bis 8 Stunden, vorzugsweise 3 bis 7 Stunden, insbesondere 4 bis 6 Stunden, nachgetrocknet.

Bei dem bevorzugtem Coextrusionsverfahren zur Herstellung der Folie wird so vorgegangen, dass die den einzelnen Schichten der Folie entsprechenden Schmelzen durch eine Flachdüse coextrudiert werden und als weitgehend amorphe Vorfolie auf einer Kühlwalze abgeschreckt. Diese Folie wird anschließend erneut erhitzt und in mindestens einer Richtung - entweder in Maschinenrichtung (MD) oder in Querrichtung (TD) - bevorzugt aber in Längs- und Querrichtung bzw. in Quer- und Längsrichtung bzw. in Längs-, in Quer- und nochmals und Längsrichtung und / oder Querrichtung verstreckt ("orientiert"). Die Folientemperaturen im Streckprozess liegen im allgemeinen 10 bis 60 °C über der Glasübergangstemperatur Tg des verwendeten Polyesters, das Streckverhältnis der Längsstreckung liegt üblicherweise bei 2,0 bis 6,0, insbesondere bei 3,0 bis 4,5, das der Querstreckung bei 2,0 bis 5,0, insbesondere bei 3,0 bis 4,5, und das der gegebenenfalls durchgeführten zweiten Längs- und Querstreckung bei 1,1 bis 5,0. Die erste Längsstreckung kann auch gleichzeitig mit der Querstreckung (Simultanstreckung) durchgeführt werden. Es folgt die Thermofixierung

der Folie bei Ofentemperaturen von 180 bis 260 °C, insbesondere von 220 bis 250 °C. Anschließend wird die Folie abgekühlt und gewickelt.

In einer bevorzugten Ausführungsform findet die Thermofixierung zwischen 220 bis 250 °C statt, und die Folie wird bei dieser Temperatur um mindestens 1 % (bevorzugt mindestens 2 %) in Querrichtung relaxiert.

In einer weiteren bevorzugten Ausführungsform findet die Thermofixierung zwischen 220 bis 250 °C statt, und die Folie wird bei dieser Temperatur um mindestens 1 % (bevorzugt mindestens 2 %) in Querrichtung relaxiert und anschließend nochmals bei Temperaturen zwischen 180 und 150°C in der Abkühlphase um wiederum mindestens 1 % (bevorzugt mindestens 2 %) in Querrichtung relaxiert.

In einer weiteren bevorzugten Ausführungsform wird die Folie mindestens um den Faktor 3,0 in MD- und TD-Richtung gestreckt, wobei die Streckung in einem Simultanrahmen stattfindet. Die Thermofixierung findet zwischen 220 bis 250 °C statt, und die Folie wird bei dieser Temperatur um mindestens 1 % in Längs- und Querrichtung relaxiert.

Die erfindungsgemäßen mehrschichtigen Folien weisen die geforderten guten mechanischen Eigenschaften auf. So beträgt der E-Modul in mindestens einer Folienrichtung (Längsrichtung (MD) und/oder Querrichtung (TD)) mindestens 500 N/mm$^2$, bevorzugt mindestens 2000 N/mm$^2$ und besonders bevorzugt mindestens 4000 N/mm$^2$. Die Reißfestigkeitswerte in mindestens einer Folienrichtung (Längsrichtung (MD) und/oder Querrichtung (TD)) sind größer als 50 N/mm$^2$, bevorzugt größer als 100 N/mm$^2$ und besonders bevorzugt größer als 150 N/mm$^2$. Die Reißdehnungswerte in mindestens einer Folienrichtung (Längsrichtung (MD) und/oder Querrichtung (TD)) sind größer als 10 % bevorzugt größer als 40 % und besonders bevorzugt größer als 80 %.

Die erfindungsgemäße mehrschichtige Folie weist in keiner Folienrichtung (weder in MD noch in TD) einen Schrumpf bei 200 °C von größer 25 % auf. Der Schrumpf bei 200 °C ist sogar kleiner als 15 % und bevorzugt kleiner als 5 %.

Es war mehr als überraschend, dass durch den Einsatz der beschriebenen Additive, kombiniert mit der bevorzugten Vortrocknung und/oder Vorkristallisation der Rohstoffe und den beschriebenen Verfahrensbedingungen eine durch elektromagnetische Strahlung aktivierbare mehrschichtige Folie mit dem geforderten Eigenschaftsprofil ohne technische Probleme (wie Verklebungen im Trockner oder Abrisse) herstellbar ist. Es wurden bei der Herstellung kaum oder keine Ablagerungen an den Düsen oder Ausgasungen beobachtet, wodurch die erfindungsgemäße Folie ausgezeichnete mechanische Eigenschaften, eine exzellente Optik, ein ausgezeichnetes Profil und eine ausgezeichnete Planlage aufweist. Sie lässt sich hervorragend verstrecken, so dass sie verfahrenssicher und wirtschaftlich rentabel hergestellt werden kann.

Des weiteren ist es sehr überraschend, dass auch das Rezyklat wieder einsetzbar ist, ohne die mechanischen Eigenschaften der Folie negativ zu beeinflussen. Auch im Vergleich zu einer nicht ausgerüsteten Folie sind die mechanischen Eigenschaften im Rahmen der Messgenauigkeit nicht negativ verändert.

Durch die Kombination ihrer Eigenschaften eignen sich die erfindungsgemäßen Folien für eine Vielzahl verschiedener Anwendungen, beispielsweise für Leiterplatten, Flachbandkabel, Smartcards, RFID-Labels, Folientastaturen und folienbasierten Schaltungen aller Art.

Die Erfindung wird im Folgenden anhand von Ausführungsbeispielen näher erläutert, ohne darauf beschränkt zu sein.

Die Messung der einzelnen Eigenschaften erfolgte dabei gemäß den folgenden Normen bzw. Verfahren:

**Messmethoden**

**Mechanische Eigenschaften**

Der E-Modul, die Reißfestigkeit, Reißdehnung und der F5-Wert werden in Längs- und Querrichtung nach ISO 527-1-2 mit Hilfe eines Zug-Dehnungsmessgerät (Fa. Zwick, Typ 010, Ulm, DE) gemessen.

**Schrumpf**

Der thermische Schrumpf wurde an quadratischen Folienmustern mit einer Kantenlänge von 10 cm bestimmt. Die Proben werden genau ausgemessen (Kantenlänge $L_0$) und werden 15 Minuten bei 200 °C in einem Umlufttrockenschrank getempert. Die Proben werden entnommen und bei Raumtemperatur genau ausgemessen (Kantenlänge L). Der Schrumpf ergibt sich aus der Gleichung

$$\text{Schrumpf [\%]} = 100 \bullet (L_0 - L) / L$$

**Standardviskosität (SV) und intrinsische Viskosität (IV)**

Die Standardviskosität SV wurde - angelehnt an DIN 53726 - als 1 %ige Lösung in Dichloressigsäure (DCE) bei 25 °C gemessen. SV (DCE) = (ηrel -1) x 1000. Die intrinsische Viskosität (IV) berechnet sich wie folgt aus der Standardviskosität (SV)

$$IV = [\eta] = 6.907 \cdot 10^{-4}\ SV\ (DCE) + 0{,}063096\ [dl/g]$$

**Messung des mittleren Durchmessers $d_{50}$**

Die Bestimmung des mittleren Durchmessers $d_{50}$ wurde mittels Laser auf einem Malvern Master Sizer nach der Standardmethode durchgeführt (andere Messgeräte sind z.B. Horiba LA 500 oder Sympathec Helos, welche das gleiche Messprinzip verwenden). Die Proben wurden dazu in eine Küvette mit Wasser gegeben und diese dann in das Messgerät gestellt. Der Messvorgang ist automatisch und beinhaltet auch die mathematische Bestimmung des $d_{50}$-Wertes. Der $d_{50}$-Wert wird dabei definitionsgemäß aus der (relativen) Summenkurve der Partikelgrößenverteilung bestimmt: Der Schnittpunkt des 50%-Ordinatenwertes mit der Summenkurve liefert auf der Abszissenachse sofort den gewünschten $d_{50}$-Wert. Wie dies zu verstehen ist, wird in der nachstehenden Abbildung näher verdeutlicht:

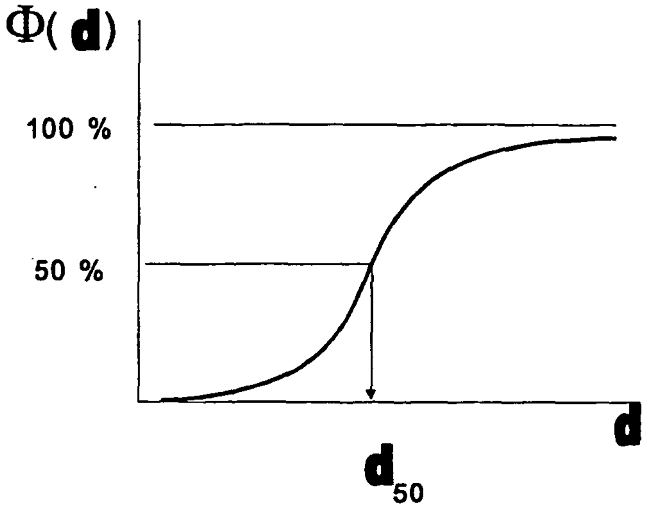


**Siegelnahtfestigkeit**

Zur Bestimmung der Siegelnahtfestigkeit wurde zwei 15 mm breite Folienstreifen übereinander gelegt und bei 130 °C, einer Siegelzeit von 0,5 s und einem Siegeldruck von 2 bar mit einem Gerät Typ NDS der Fa. Brugger Feinmechanik (München, DE) mit einseitig beheizter Siegelbacke gesiegelt. Die gesiegelte Fläche beträgt etwa 15 x 9 mm. Die Siegelnahtfestigkeit wurde nach der T-Peel-Methode mit Hilfe eines Zug-Dehnungsmessgerät (Fa. Zwick, Typ 010, Ulm, DE) bestimmt. Dabei werden die beiden Streifenenden in die gegenüberliegenden Kluppen eingespannt und mit einer Geschwindigkeit von 200 mm/min auseinander gezogen. Die maximale dabei gemessenen Kraft ist die Siegelnahtfestigkeit und wird in N/15 mm angegeben.

**Folienherstellung**

Polyester-Chips wurden gemäß den in den Beispielen angegebenen Verhältnissen gemischt und in einem Wirbelschichttrockner bei 155°C für 1 Minute vorkristallisiert, anschließend für 3 Stunden in einem Schachttrockner bei 150°C getrocknet und bei 290 °C in einem Einschneckenextruder aufgeschmolzen. Die geschmolzenen Polymerstränge wurden in einer Coextrusionsdüse zusammengeführt und über eine Abzugswalze (Temperatur der Walze 20 °C) abgezogen. Der Film wurde um den Faktor 3,5 in Maschinenrichtung bei 116 °C (Folientemperatur im Streckspalt) gestreckt und in einem Rahmen bei 110 °C eine Querstreckung um den Faktor 3,2 durchgeführt. Anschließend wurde die Folie

bei 229 °C thermofixiert und in Querrichtung um 1 % bei Temperaturen von 229 - 200 °C und ein weiteres mal um 1 % bei Temperaturen zwischen 180 und 150 °C relaxiert. Die Produktionsgeschwindigkeit (Endfoliengeschwindigkeit) beträgt 300 m/min.
Die Endfoliendicke beträgt 50 μm.

## Beispiele

In den Beispielen kommen die folgenden Rohstoffe zum Einsatz:

### Masterbatch MB1:

10 Gew.-% PK3095 der Firma Ferro und 90 Gew.-% Polyethylenterephtalat (PET)

### Masterbatch MB2:

10 Gew.-% PK3095 der Firma Ferro (DE) und 90 Gew.-% Polybutylenterephthalat (PBT)

### Masterbatch MB3:

4 Gew.-% $SiO_2$-Partikel Aerosil TT600 der Firma Degussa (DE) ($d_{50}$ der Agglomerate ca. 300 nm; Primärteilchen $d_{50}$ ca. 50 nm) und 96 Gew.-% Polyethylenterephtalat (PET)

### Masterbatch MB4:

4 Gew.-% $SiO_2$-Partikel Aerosil TT600 der Firma Degussa (DE) ($d_{50}$ der Agglomerate ca. 300 nm; Primärteilchen $d_{50}$ ca. 50 nm) und 96 Gew.-% Polybuthylenterephtalat (PBT)

### Masterbatch MB5:

4 Gew.-% $CaCO_3$-Partikel Omyacarb BP der Firma Omya (USA) ($d_{50}$ der Partikel 22 μm), 96 Gew.-% Polyethylenterephtalat (PET)

### Masterbatch MB6:

10 Gew.-% PK3095 der Firma Ferro (DE) und 90 Gew.-% Polyethylennaphtalat (PEN)

### Masterbatch MB7:

4 Gew.-% $SiO_2$-Partikel Aerosil TT600 der Firma Degussa (DE) ($d_{50}$ der Agglomerate ca. 300 nm; Primärteilchen $d_{50}$ ca. 50 nm) und 96 Gew.-% Polyethylennaphtalat (PEN)

### Masterbatch MB8:

Das Masterbatch MB8 enthält 6 Gew.-% M-Ester der Firma Sanko Co. Ltd. (Cas Nr. 63562-34-5) und 94 Gew.% Polyethylenterephthalat der Firma KoSa (DE)

### Rohstoff R1:

100 Gew.-% Polyethylenterephthalat RT49 der Firma Kosa (DE)

### Rohstoff R2:

25 Gew.-% Aerosil 90 der Firma Degussa (DE), 5 Gew.-% PK3095 der Firma Ferro (DE) und 70 Gew.-% Polybutylenterephtalat (PBT)

### Rohstoff R3:

100 Gew.-% Polybutylenterephthalat

**Rohstoff R4:**

100 Gew.-% Polyethylennaphthalat

**Rohstoff R5:**

18 Gew.-% Bariumsulfat Typ Blanc-fixe XR-SU der Firma Sachtleben (DE), 0,03 Gew.-% optischer Aufheller Hostalux KS von Firma Clariant (DE), 81,97 Gew.-% Polyethylenterephthalat RT49 der Firma Kosa (Deutschland)

**Rohstoff R6:**

100 Gew.-% Copolyester bestehend aus 78 Mol-% Ethylenterephthalat und 22 Mol-% Ethylenisophthalat (hergestellt durch Umesterung in Gegenwart eines Mangankatalysators, Mangankonzentration: 100 ppm)

**Beispiel 1**

Es wurde eine ABA-Folie mit einer Dicke der Basisschicht von 46 μm und Deckschichten A mit je 2 μm wie oben angegeben hergestellt.
Rohstoffmischung Deckschichten A: 50 Gew.-% MB1; 25 Gew.-% MB3; 25 Gew.-% R1 Rohstoffmischung Basisschicht B: 100 Gew.-% R1
Die Eigenschaften der Folie können Tabelle 1 entnommen werden.

**Beispiel 2**

Beispiel 1 wurde wiederholt. In die Basisschicht B wird jedoch zusätzlich Rezyklat gegeben, welches aus der Folie aus Beispiel 1 hergestellt wurde.
Rohstoffmischung Deckschichten A: 50 Gew.-% MB1; 25 Gew.-% MB3; 25 Gew.-% R1 Rohstoffmischung Basisschicht B: 50 Gew.-% R1; 50 Gew.-% Rezyklat
Die Eigenschaften der Folie können Tabelle 1 entnommen werden.

**Beispiel 3**

Beispiel 1 wurde wiederholt.
Rohstoffmischung Deckschichten A: 50 Gew.-% MB1; 50 Gew.-% R1
Rohstoffmischung Basisschicht B: 100 Gew.-% R1
Die Eigenschaften der Folie können Tabelle 1 entnommen werden.

**Beispiel 4**

Es wurde eine ABC-Folie mit einer Dicke der Basisschicht von 46 μm und Deckschichten A und C mit je 2 μm wie oben angegeben hergestellt.
Rohstoffmischung Deckschicht A: 50 Gew.-% MB1; 25 Gew.-% MB3; 25 Gew.-% R1 Rohstoffmischung Basisschicht B: 100 Gew.-% R1
Rohstoffmischung Deckschicht C: 25 Gew.-% MB3; 75 Gew.-% R1
Die Eigenschaften der Folie können Tabelle 1 entnommen werden.

**Beispiel 5**

Beispiel 1 wurde wiederholt.
Rohstoffmischung Deckschicht A: 50 Gew.-% MB1; 25 Gew.-% MB3; 25 Gew.-% R1 Rohstoffmischung Basisschicht B: 25 Gew.-% MB3; 75 Gew.-% R1
Die Eigenschaften der Folie können Tabelle 1 entnommen werden.

**Beispiel 6**

Beispiel 1 wurde wiederholt.
Rohstoffmischung Deckschicht A: 50 Gew.-% MB1; 25 Gew.-% MB3; 25 Gew.-% R1 Rohstoffmischung Basisschicht B: 100 Gew.-% R5

Die Eigenschaften der Folie können Tabelle 1 entnommen werden.

**Beispiel 7**

Beispiel 1 wurde wiederholt.
Rohstoffmischung Deckschicht A: 50 Gew.-% MB1; 25 Gew.-% MB3; 25 Gew.-% R1
Rohstoffmischung Basisschicht B: 25 Gew.-% MB8; 75 Gew.-% R1
Die Folie wurde einem Brandtest gemäß UL94 VTM unterzogen und erreichte die Brandklasse VTM-0. Die sonstigen Eigenschaften der Folie können Tabelle 1 entnommen werden.

**Beispiel 8**

Beispiel 1 wurde wiederholt.
Rohstoffmischung Deckschicht A: 50 Gew.-% MB6; 25 Gew.-% MB7; 25 Gew.-% R4 Rohstoffmischung Basisschicht B: 85 Gew.-% R1; 15 Gew.-% R4
Die Eigenschaften der Folie können Tabelle 1 entnommen werden.

**Beispiel 9**

Beispiel 1 wurde wiederholt.
Rohstoffmischung Deckschicht A: 50 Gew.-% MB2; 25 Gew.-% MB3; 25 Gew.-% R1
Rohstoffmischung Basisschicht B: 100 Gew.-% R1
Die Eigenschaften der Folie können Tabelle 1 entnommen werden.

**Beispiel 10**

Es wurde eine ABC-Folie mit einer Dicke der Basisschicht von 47 µm, einer Deckschicht A mit 2 µm und einer siegelfähigen Deckschicht C mit 1 µm wie oben angegeben hergestellt.
Rohstoffmischung Deckschicht A: 50 Gew.-% MB1; 25 Gew.-% MB3; 25 Gew.-% R1
Rohstoffmischung Basisschicht B: 100 Gew.-% R1
Rohstoffmischung Deckschicht C: 100 Gew.-% R6
Die Siegelnahtfestigkeit der Folie (C-Seite / C-Seite) betrug 2,7 N/15 mm. Die sonstigen Eigenschaften der Folie können Tabelle 1 entnommen werden.

**Beispiel 11**

Beispiel 1 wurde mit geänderten Rohstoffmischungen wiederholt.
Rohstoffmischung Deckschicht A: 100 Gew.-% R2
Rohstoffmischung Basisschicht B: 100 Gew.-% R1
Die Folienherstellung war nicht einfach, da es gelegentlich zu Abrissen kam. Darüber hinaus kam es gelegentlich zu einer Delamination der Deckschichten. Die Eigenschaften der Folie können Tabelle 1 entnommen werden.

**Vergleichsbeispiel 1**

Es wurde versucht, wie oben angegeben aus dem Rohstoff R2 (angelehnt an den Rohstoff aus dem Beispiel der EP-A-1 274 288) eine ABA-Folie mit einer Dicke der Basisschicht von 46 µm und Deckschichten A mit je 2 µm herzustellen.
Rohstoffmischung Deckschicht A: 100 Gew.-% R2
Rohstoffmischung Basisschicht B: 100 Gew.-% R2
Die Verstreckung der Folie erwies sich als unmöglich, da jeder Streckversuch zu Abrissen führte. Es konnte keine Folie hergestellt werden.

**Vergleichsbeispiel 2**

Beispiel 1 wurde wiederholt.
Rohstoffmischung Deckschicht A: 50 Gew.-% MB1; 25 Gew.-% MB3; 25 Gew.-% R1
Rohstoffmischung Basisschicht B: 25 Gew.-% MB5; 75 Gew.-% R1
Es konnten nur kleine Mengen der Folie hergestellt werden, da es oft zu Abrissen kam. Darüber hinaus kam es zu einer

Delamination der Deckschichten. Die Eigenschaften der Folie können Tabelle 1 entnommen werden.

**Vergleichsbeispiel 3**

Beispiel 1 wurde wiederholt. Die Thermofixierung erfolgte jedoch nicht wie oben angegeben bei 229 °C, sondern bei 150 °C, und es erfolgte keine Relaxation. Die Eigenschaften der Folie können Tabelle 1 entnommen werden.

**Leiterbahnerzeugung:**

Die hergestellten Folien werden im Bereich der aufzubringenden Leiterbahnen einer Infrarot-Laserstrahlung, die von einem diodengepumpten Nd:YAG-Laser erzeugt wird (Microline 3D IR 160 der Firma LPKF AG (Deutschland)), mit einer Intensität bestrahlt, die einen geringfügigen Abtrag erzeugt, der mit einer strukturierten Entstehung von Metallkeimen verbunden ist. Nach kurzer Behandlung in einem demineralisiertes Wasser enthaltenden Ultraschall-Reinigungsbad wird die Folie durch ein handelsübliches chemisch reduktives Verkupferungsbad geführt. Hier werden in den bestrahlten Bereichen die Leiterbahnen aufgebaut.

**Ergebnisse der Leiterbahnerzeugung:**

Die erzeugten Leiterbahnen wurden mittels eines Lichtmikroskops (Auflicht) bei 20-facher Vergrößerung visuell beurteilt. Die Geschlossenheit der Kupferschicht wurde visuell bewertet und in die folgenden Kategorien eingeteilt: gut, weniger gut und schlecht.

**Tabelle 1**

| Beispiel | E-Modul MD in $N/mm^2$ | E-Modul TD in $N/mm^2$ | Reißfestigkeit MD in $N/mm^2$ | Reißfestigkeit TD in N/mm2 | Reißdehnung MD in % | Reißdehnung TD in % | Schrumpf MD 200 °C | Schrumpf TD 200 °C | Visuelles Erscheinungsbild der Folie | Leiterbahnerzeugung |
|---|---|---|---|---|---|---|---|---|---|---|
| 1 | 4000 | 5300 | 175 | 260 | 163 | 112 | 4,2 | 2,1 | leicht grau | gut |
| 2 | 4100 | 5400 | 172 | 265 | 164 | 110 | 4,3 | 2,0 | leicht grau | gut |
| 3 | 4200 | 5100 | 177 | 270 | 165 | 105 | 4,5 | 2,2 | grau | weniger gut |
| 4 | 4300 | 5300 | 173 | 268 | 160 | 111 | 4,2 | 2,3 | leicht grau | gut |
| 5 | 4400 | 5200 | 169 | 257 | 155 | 100 | 4,0 | 2,5 | leicht grau | gut |
| 6 | 4200 | 5100 | 163 | 240 | 160 | 110 | 4,3 | 2,4 | weiß | gut |
| 7 | 3950 | 5000 | 160 | 225 | 178 | 118 | 4,7 | 2,7 | leicht grau | gut |
| 8 | 3800 | 4900 | 163 | 248 | 172 | 115 | 4,8 | 2,6 | leicht grau | gut |
| 9 | 4100 | 5200 | 165 | 252 | 150 | 105 | 4,3 | 2,3 | leicht grau | gut |
| 10 | 4200 | 5100 | 164 | 241 | 156 | 119 | 4,1 | 2,2 | leicht grau | gut |
| 11 | 4100 | 5300 | 155 | 230 | 40 | 73 | 4,2 | 2,7 | leicht grau | gut*) |
| Vergleichs beispiel | | | | | | | | | | |
| 1 | keine Folie erhalten | keine Folie erhalten | keine Folie erhalten | keine Folie erhalten | keine Folie erhalten | keine Folie erhalten | keine Folie erhalten | keine Folie erhalten | keine Folie erhalten | keine Folie erhalten |
| 2 | 4200 | 5400 | 32 | 41 | 25 | 39 | 4,3 | 2,5 | weiß | gut |
| 3 | 4400 | 5100 | 140 | 215 | 200 | 120 | 23 | 25 | leicht grau | gut**) |

*) Delamination der Deckschichten mit den Leiterbahnen **) Nach Laserbestrahlung bildeten sich Falten

## Patentansprüche

1. Mehrschichtige, mindestens monoaxial orientierte Polyesterfolie mit einer Gesamtdicke von 5 - 500 μm, **dadurch gekennzeichnet, dass** sie eine Metallverbindung enthält, welche ein Spinell ist und die bei Bestrahlung mit elektromagnetischer Strahlung in dem Polyester Metall in elementarer Form freisetzt.

2. Polyesterfolie nach Anspruch 1, **dadurch gekennzeichnet, dass** die Metallverbindung $CuCr_2O_4$ ist.

3. Polyesterfolie nach einem der Ansprüche 1 oder 2, **dadurch gekennzeichnet, dass** die Metallverbindungin der Folie in einer Menge von 0,1 bis 15,0 Gew.-% enthalten ist.

4. Polyesterfolie nach einem der Ansprüche 1 bis 3, **dadurch gekennzeichnet, dass** sie partikuläre Additive enthält.

5. Polyesterfolie nach einem der Ansprüche 1 bis 4, **dadurch gekennzeichnet, dass** sie auf mindestens einer Oberfläche eine Silikonbeschichtung aufweist.

6. Polyesterfolie nach einem der Ansprüche 1 bis 5, **dadurch gekennzeichnet, dass** mindestens eine Schicht aus einem Polyester aufgebaut ist, der als Dicarbonsäurekomponente 10 bis 100 Mol-% Terephthalat enthält (bezogen auf die Gesamtmenge der vorhandenen Dicarbonsäurekomponenten).

7. Polyesterfolie nach einem der Ansprüche 1 bis 6, **dadurch gekennzeichnet, dass** mindestens eine Schicht aus einem Polyester aufgebaut ist, der als Dicarbonsäurekomponente 10 bis 100 Mol-% 2,6-Naphthalat enthält (bezogen auf die Gesamtmenge der vorhandenen Dicarbonsäurekomponenten).

8. Polyesterfolie nach einem der Ansprüche 1 bis 7, **dadurch gekennzeichnet, dass** sie einen E-Modul in mindestens einer Folienrichtung (Längsrichtung (MD) und/oder Querrichtung (TD)) von größer als 500 $N/mm^2$ aufweist.

9. Polyesterfolie nach einem der Ansprüche 1 bis 8, **dadurch gekennzeichnet, dass** sie Reißfestigkeitswerte in mindestens einer Folienrichtung (Längsrichtung (MD) und/oder Querrichtung (TD)) von größer als 50 $N/mm^2$ aufweist.

10. Polyesterfolie nach einem der Ansprüche 1 bis 9, **dadurch gekennzeichnet, dass** sie Reißdehnungswerte in mindestens einer Folienrichtung (Längsrichtung (MD) und/oder Querrichtung (TD)) von größer als 10 % aufweist.

11. Polyesterfolie nach einem der Ansprüche 1 bis 10, **dadurch gekennzeichnet, dass** sie in keiner Folienrichtung (weder in MD noch in TD) einen Schrumpf bei 200 °C von größer 25 % aufweist.

12. Polyesterfolie nach einem der Ansprüche 1 bis 11, **dadurch gekennzeichnet, dass** die Folie mindestens zweischichtig ist und mindestens aus einer Basisschicht und einer Deckschicht besteht.

13. Polyesterfolie nach einem der Ansprüche 1 bis 12, **dadurch gekennzeichnet, dass** die Folie mindestens dreischichtig ist und mindestens aus einer Basisschicht und zwei Deckschichten besteht.

14. Polyesterfolie nach einem der Ansprüche 12 oder 13, **dadurch gekennzeichnet, dass** die Metallverbindung in einer der Schichten der Mehrschichtfolie vorhanden ist.

15. Polyesterfolie nach einem der Ansprüche 12 oder 13, **dadurch gekennzeichnet, dass** die Metallverbindung in der oder den Deckschichten der Mehrschichtfolie vorhanden ist.

16. Polyesterfolie nach einem der Ansprüche 12 oder 13, **dadurch gekennzeichnet, dass** eine der Deckschichten siegelfähig ist.

17. Verfahren zur Herstellung einer Polyesterfolie nach Anspruch 1, **dadurch gekennzeichnet, dass** man die den einzelnen Schichten der Folie entsprechenden Schmelzen, wobei mindestens eine eine Metallverbindung,welche ein Spinell ist und die bei Bestrahlung mit elektromagnetischer Strahlung in dem Polyester Metall in elementarer Form freisetzt, enthält, zusammen durch eine Schlitzdüse extrudiert, abkühlt, erneut erhitzt und anschließend mindestens in einer Richtung orientiert und dann thermofixiert.

18. Verwendung einer Folie nach Anspruch 1 in Leiterplatten, Flachbandkabeln, Smartcards, RFID-Labels, Folientastaturen und folienbasierten Schaltungen.

## Claims

1. Multilayer, at least monoaxially oriented polyester film with a total thickness of from 5 to 500 μm, **characterized in that** it comprises a metal compound which is a spinel and which on irradiation with electromagnetic radiation liberates a metal in elemental form within the polyester.

2. Polyester film according to Claim 1, **characterized in that** the metal compound is $CuCr_2O_4$.

3. Polyester film according to any of Claims 1 or 2, **characterized in that** the amount of the metal compound present in the film is from 0.1 to 15.0 % by weight.

4. Polyester film according to any of Claims 1 to 3, **characterized in that** it comprises particulate additives.

5. Polyester film according to any of Claims 1 to 4, **characterized in that** it has a silicone coating on at least one surface.

6. Polyester film according to any of Claims 1 to 5, **characterized in that** at least one layer is composed of a polyester which contains, as dicarboxylic acid component, from 10 to 100 mol % of terephthalate (based on the total amount of the dicarboxylic acid components present).

7. Polyester film according to any of Claims 1 to 6, **characterized in that** at least one layer is composed of a polyester which contains, as dicarboxylic acid component, from 10 to 100 mol % of 2,6-naphthalate (based on the total amount of the dicarboxylic acid components present).

8. Polyester film according to any of Claims 1 to 7, **characterized in that** it has a modulus of elasticity in at least one film direction (longitudinal (MD) and/or transverse (TD)) greater than 500 $N/mm^2$.

9. Polyester film according to any of Claims 1 to 8, **characterized in that** it has ultimate tensile strength values in at least one film direction (longitudinal (MD) and/or transverse (TD)) greater than 50 $N/mm^2$.

10. Polyester film according to any of Claims 1 to 9, **characterized in that** it has tensile strain at break values in at least one film direction (longitudinal (MD) and/or transverse (TD)) greater than 10 %.

11. Polyester film according to any of Claims 1 to 10, **characterized in that** it does not have shrinkage greater than 25 % at 200°C in any film direction (MD or TD).

12. Polyester film according to any of Claims 1 to 11, **characterized in that** the film has at least two layers and is composed at least of one base layer and one outer layer.

13. Polyester film according to any of Claims 1 to 12, **characterized in that** the film has at least three layers and is composed at least of one base layer and two outer layers.

14. Polyester film according to Claim 12 or 13, **characterized in that** the metal compound is present in one of the layers of the multilayer film.

15. Polyester film according to Claim 12 or 13, **characterized in that** the metal compound is present in the outer layer (s) of the multilayer film.

16. Polyester film according to Claim 12 or 13, **characterized in that** one of the outer layers is sealable.

17. Process for producing a polyester film according to Claim 1, **characterized in that** it comprises extruding, together through a slot die, the melts corresponding to the individual layers of the film, where at least one melt comprises metal compound which is a spinel and which on irradiation with electromagnetic radiation liberates a metal in elemental form within the polyester, cooling, reheating, and then orienting in at least one direction, and then heat-setting.

**18.** Use of a film according to Claim 1 in printed circuit boards, ribbon cables, smart cards, RFID labels, membrane keyboards, and film-based circuits.

## Revendications

**1.** Film de polyester multicouche orienté au moins monoaxialement, ayant une épaisseur totale de 5-500 µm, **caractérisé en ce qu'**il contient un composé métallique qui est un spinelle et qui, lors d'irradiation avec un rayonnement électromagnétique, libère dans le polyester du métal sous forme élémentaire.

**2.** Film de polyester selon la revendication 1, **caractérisé en ce que** le composé métallique est $CuCr_2O_4$.

**3.** Film de polyester selon la revendication 1 ou 2, **caractérisé en ce que** le composé métallique est contenu dans le film en une proportion de 0,1 à 15,0 % en poids.

**4.** Film de polyester selon l'une quelconque des revendications 1 à 3, **caractérisé en ce qu'**il contient des additifs particulaires.

**5.** Film de polyester selon l'une quelconque des revendications 1 à 4, **caractérisé en ce qu'**il comporte un revêtement silicone sur au moins une surface.

**6.** Film de polyester selon l'une quelconque des revendications 1 à 5, **caractérisé en ce qu'**il est constitué d'au moins une couche à base d'un polyester qui contient en tant que composant acide dicarboxylique de 10 à 100 % en moles de téréphtalate (par rapport à la quantité totale des composants de type acide dicarboxylique présents).

**7.** Film de polyester selon l'une quelconque des revendications 1 à 6, **caractérisé en ce qu'**il est constitué d'au moins une couche à base d'un polyester qui contient en tant que composant acide dicarboxylique de 10 à 100 % en moles de 2,6-naphtalate (par rapport à la quantité totale des composants de type acide dicarboxylique présents).

**8.** Film de polyester selon l'une quelconque des revendications 1 à 7, **caractérisé en ce qu'**il présente un module d'élasticité dans au moins un sens du film [sens longitudinal (MD) et/ou sens transversal (TD)] supérieur à 500 $N/mm^2$.

**9.** Film de polyester selon l'une quelconque des revendications 1 à 8, **caractérisé en ce qu'**il présente des valeurs de la résistance à la traction dans au moins un sens du film [sens longitudinal (MD) et/ou sens transversal (TD)] supérieures à 50 $N/mm^2$.

**10.** Film de polyester selon l'une quelconque des revendications 1 à 9, **caractérisé en ce qu'**il présente des valeurs de l'allongement en traction dans au moins un sens du film [sens longitudinal (MD) et/ou sens transversal (TD)] supérieures à 10 %.

**11.** Film de polyester selon l'une quelconque des revendications 1 à 10, **caractérisé en ce qu'**il ne présente dans aucun sens du film (ni dans MD, ni dans TD) un retrait de plus de 25 % à 200 °C.

**12.** Film de polyester selon l'une quelconque des revendications 1 à 11, **caractérisé en ce que** le film est au moins bicouche et est au moins constitué d'une couche de base et d'une couche de recouvrement.

**13.** Film de polyester selon l'une quelconque des revendications 1 à 12, **caractérisé en ce que** le film est au moins tricouche et est au moins constitué d'une couche de base et de deux couches de recouvrement.

**14.** Film de polyester selon la revendication 12 ou 13, **caractérisé en ce que** le composé métallique est présent dans l'une des couches du film multicouche.

**15.** Film de polyester selon la revendication 12 ou 13, **caractérisé en ce que** le composé métallique est présent dans la couche ou les couches de recouvrement du film multicouche.

**16.** Film de polyester selon la revendication 12 ou 13, **caractérisé en ce que** l'une des couches de recouvrement est soudable.

**17.** Procédé pour la fabrication d'un film de polyester selon la revendication 1, **caractérisé en ce que** les masses fondues correspondant aux couches individuelles du film, où au moins une contient un composé métallique qui est un spinelle et qui, lors d'irradiation avec un rayonnement électromagnétique, libère dans le polyester du métal sous forme élémentaire, sont extrudées ensemble à travers une filière plate, le film est refroidi, chauffé de nouveau puis orienté au moins dans un sens, et ensuite thermofixé.

**18.** Utilisation d'un film selon la revendication 1, dans des cartes à circuits imprimés, des câbles en ruban, des cartes à puce, des étiquettes à radio-identification RFID, des claviers souples et des circuits à base de film.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 1274288 A
- US 5728339 A